# EUROPEAN PATENT SPECIFICATION

(11) **EP 2 881 974 B1**
(45) Date of publication and mention of the grant of the patent: **18.07.2018**
(21) Application number: 13197009.7
(22) Date of filing: 12.12.2013
(51) Int. Cl.: H01J 37/32, C23C 14/52, G01N 23/223, H05H 1/00, H01J 37/34

(54) **Method and device for controlling reactive sputtering deposition**
Verfahren und Vorrichtung zur Steuerung reaktiver Sputterabscheidung
Procédé et dispositif de contrôle de dépôt par pulvérisation cathodique réactive

(30) Priority: 04.12.2013 EP 13195583
(43) Date of publication of application: 10.06.2015
(73) Proprietor: Institute of Solid State Physics, University of Latvia, 1063 Riga (LV)
(72) Inventor: Purans, Juris, LV-1010 Riga (LV)
(74) Representative: Fortuna, Jevgenijs

(56) References cited:
- WO-A2-2005/059197
- DE-A1- 4 406 421
- US-B1- 6 697 454
- DEHLINGER ET AL.: "Spatial resolution of confocal XRF technique using capillary optics", NANOSCALE RESEARCH LETTERS, vol. 8, 271, 7 June 2013 (2013-06-07), page 6PP, XP055104413,

## Description

### Technical field

The present invention relates to the methods and devices for controlling a reactive sputtering deposition of a selected material.

### Background Art

Sputtering is a process whereby atoms are ejected from a solid target material due to bombardment of the target by energetic particles. In reactive sputtering, the deposited film (e.g. oxide and nitride film) is formed by chemical reaction between the target material and a gas introduced into the vacuum chamber. Film stoichiometry is an important parameter for optimizing functional properties like e.g. stress and index of refraction.

In many cases, the process of reactive sputtering occurs in two modes: metallic and oxidized. The metal surface can be metallic and have a high sputtering rate. However often the resulting materials are not growing stoichiometrically or surface of metal can be completely oxidized as a result of a large supply of gas, such as oxygen, resulting in the lower rate of sputtering and obtaining fully oxidized material. Thus the reactive sputtering process can be unstable and requires control. The composition of the film can be controlled by adjusting the relative pressures of the inert and reactive gases. This, in turn, requires special feedback - information on condition of the surface of the sputtering target. Also in many cases, the optimal material properties can be obtained in a transient mode, for example, preparation of transparent electrodes: In₂O₃:Sn (ITO), or ZnO:Al(AZO). This is another reason of the necessity to get the feedback on the reactive sputtering deposition on a surface of a material.

Most prior art solutions provide such feedback on the basis of optical emission spectroscopy signal or voltage on discharge (US4166784), optical controlling a thickness of the layer on the substrate (EP2549521), emission intensity (JP2010229523) or volt-ampere characteristic of a magnetron (EP1640472).

There is known a method for controlling a reactive sputtering process (EP0501016), wherein the working point, defined by the value of one of the two factors determining the electric power absorption of the reactive sputtering process, namely working voltage or working current intensity, on the physical characteristic curve of cathode voltage or working current intensity is adjusted and kept constant via the reactive gas flow of the sputtering unit by metering of the reactive gas, introduced into the process chamber.

The disadvantages of the known solutions, where the feedback is received on the basis of optical emission signal collected from plasma; volt-ampere characteristic of a process; or gases pressure in the chamber is that such solutions do not provide information of the poisoning (oxidation) state of a target surface during a reactive sputtering process.

There is also known a method for controlling reactive magnetron sputtering process (EP2484796) using a reactive gas, regulating the process pressure by means of the flow of the reactive gas. Oscillations of the flow of the reactive gas are determined and used as feedback to determine the process pressure.

There is also known a confocal X-ray fluorescence (XRF) microscopy (Dehlinger et al. Spatial resolution of confocal XRF technique using capillary optics. Nanoscale Research Letters 2013, 8:271). XRF is a technique for elemental analysis with a high sensitivity. The spatial resolution is presently limited by the size of the primary excitation X-ray beam. A confocal-type XRF used to estimate the ultimate lateral resolution which could be reached in chemical mapping of a sample using known solution. A polycapillary lens was used to focus the primary X-ray beam of X-ray source, while the fluorescence signal was collected by a silicon drift detector (SDD) through a cylindrical monocapillary. This system was used to characterize the geometry of the fluorescent zone.

There is also known a method and device for magnetron sputtering (WO 2005/059197) and X-ray analytical techniques applied to combinatorial library screening (US 6697454 B1).

### Disclosure of Invention

The goal of the proposed invention is to eliminate the disadvantages of the prior art and to provide a method and device for controlling reactive sputtering deposition and to determine the poisoning (oxidation) state of a target surface during a reactive sputtering process.

The set goal is achieved by the proposed device for controlling a reactive sputtering deposition of a selected material, comprising: a vacuum chamber; a means for supplying of an inert and reactive gas into the vacuum chamber; a means adapted for providing a command to the means for supplying of an inert and/or reactive gas into the vacuum chamber; a source adapted for generating plasma and/or creating a flux of sputtered particles of material; a means adapted for holding or placing on it a substrate to be subjected to sputtering of a film of a selected material; an X-ray source adapted to expose a sputtering target by an X-ray beam; an X-ray fluorescence polycapillary confocal probe adapted to be placed inside of the vacuum chamber and comprising an X-ray optic, where the probe is adapted to collect the X-ray fluorescence signals from a part of the sputtering target and direct them to a signal detecting unit; an X-ray energy sensitive detector being optically connected with the polycapillary confocal probe such as to enable the X-ray optic to direct X-ray fluorescence beam towards the detector from the optic's input end facing the surface of the sputtering target; where the X-ray energy sensitive detector being connected at least with the means for processing the detected signals or interpreting the signals received on the state of oxidation of the target. The X-ray fluorescence probe is preferably provided with an y- and/or z- axis manipulator allowing to direct the input end of the X-ray fluorescence probe in y- and/or z- axis direction (to allow the probe to scan the sputtering target in the length and breadth directions and measure the quantity of X-ray fluorescence being emitted from the whole surface of the sputtering target, or at least its substantial part).

The set goal is also achieved by the proposed method for controlling a reactive sputtering deposition of a selected material, comprising the steps of sputtering the selected material from the sputtering target toward the substrate at a predetermined electrical power; monitoring the quantity of X-ray fluorescence being emitted from the sputtering target; adjusting the relative pressure of the inert and/or reactive gas so that the quantity of the radiation being emitted from the studied area and the sputtering target becomes predetermined one. The step of monitoring the quantity of X-ray fluorescence being emitted from the sputtering target comprises: exposing to radiation of the sputtering target by a beam from the X-ray source; directing an input end of an X-ray fluorescence probe towards the sputtering target to enable collection the X-ray fluorescence signal from a part of the sputtering target; collecting the X-ray fluorescence signals by the X-ray fluorescence polycapillary confocal probe's input end facing the sputtering target and directing the collected X-ray fluorescence signals towards the X-ray energy sensitive detector. The method further comprises the steps of directing an input end of the X-ray fluorescence probe to another part(s) of the sputtering target (e.g. y- and/or z- axis direction to allow the probe to scan the sputtering target in the length and breadth directions and measure the quantity of X-ray fluorescence being emitted from the whole surface of the sputtering target, or at least its substantial part); collecting the X-ray fluorescence signals by the probe's input end facing the sputtering target and directing the collected X-ray fluorescence signals towards an X-ray energy sensitive detector.

### Brief Description of Drawings

Fig. 1 shows a schematic structure of a plasma device adapted for controlling reactive sputtering deposition, using local X-ray fluorescence probe;
Fig. 2 shows the scheme of collection the XRF signal from a surface of a reactive sputtering target.

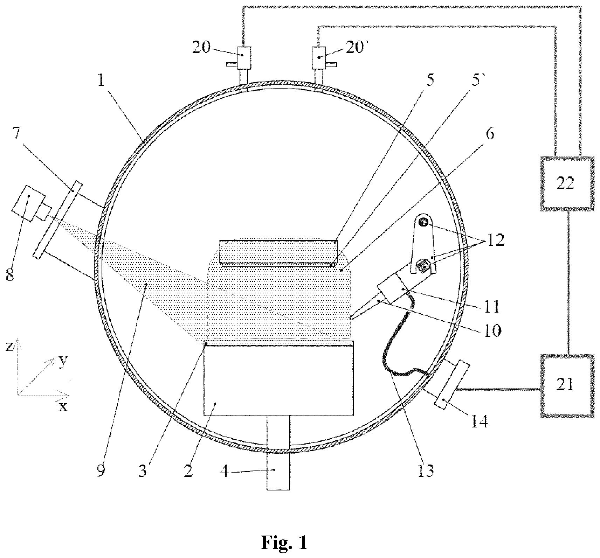

A device (Fig. 1) for controlling a reactive sputtering deposition of a selected material comprises: a vacuum chamber 1; in the chamber 1 located: a source 2 adapted for generating plasma 6 or creating a flux of sputtered particles of material (the source 2 can be a magnetron); a sputtering target 3, magnetron support or holder 4; a means 5 adapted for holding or placing on it a substrate 5' to be subjected to reactive deposition of a selected material. The chamber 1 is provided with a window 7 adapted allow an X-ray beam 9 produced by the X-ray source 8 (X-ray tube or synchrotron radiation), placed outside or inside the chamber 1, to pass through it into the vacuum chamber 1. The X-ray source 8 is placed so to expose the sputtering target 3 by the X-ray beam 9.

The proposed device further comprises the X-ray fluorescence polycapillary confocal probe 10 and an X-ray energy sensitive detector 11 (e.g. Silicon drift detector) placed inside or outside the chamber 1.

The device may further contain a manipulator 12, adapted to controllably move the polycapillary confocal probe 10 in y- and/or z- axis direction to allow the probe 10 to scan the sputtering target 3 in length and breadth directions and measure the quantity of X-ray fluorescence being emitted from the selected part 19 of the surface of the sputtering target 3.

The position 13 in Fig. 1 shows means for connecting the X-ray energy sensitive detector 11 located in the chamber 1 with the means 21 for processing the detected signals or interpreting the signals received on the state of oxidation of the target. The means 13 are put through the window 14.

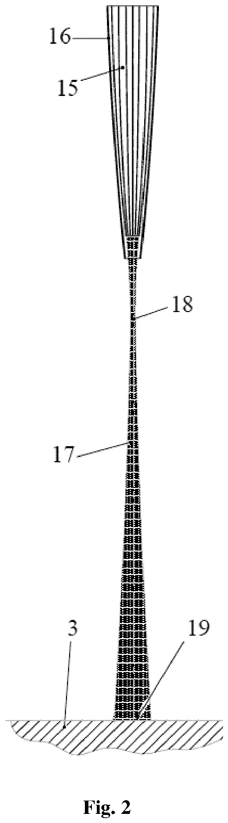

The X-ray fluorescence polycapillary confocal probe 10 is adapted to collect the X-ray fluorescence signal 17 (Fig. 2) emitted from a selected part 19 of the surface of the sputtering target 3 irradiated by X-rays from the source 8; the X-ray fluorescence polycapillary confocal probe 10 with focus position 18 comprising an X-ray policapillary optics 15, the optic 15 having an input end facing the sputtering target 3 (X-ray fluorescence photons emitted from the selected part 19 of the sputtering target 3), and an output end facing the X-ray detector 11. The optic 15 is preferably accommodated in a casing 16 (adapted to protect the optic 15 from external factors), which has an opening at an end one, where the optic's 15 end facing the sputtering target 3 is located and an opening at an end two, where the optic's 15 output end facing the X-ray detector 11 is located.

The proposed device further comprises: a means 20 and 20' for supplying of an inert and reactive gas into the vacuum chamber 1; a means 21 for processing and interpreting the signals received; a means 22 adapted for providing a command to the means 20 and 20' for supplying of an inert and reactive gas into the vacuum chamber 1. The X-ray energy sensitive detector 11 is being connected at least with the means 21 for processing and interpreting the signals received, which are connected with the a means 22 adapted for providing a command to the means 20 and 20' for supplying of an inert and/or reactive gas into the vacuum chamber 1.

After placing a sputtering target 3 of selected material and a substrate 5' into the vacuum chamber 1, the chamber 1 is being vacuumed. An inert and reactive gas is supplied into the vacuum chamber 1 through the means 20 and 20'. As a result of operation of the magnetron 2, the material from the sputtering target 3 is being ejected onto the substrate 5'. The X-ray source 8 exposes to radiation the sputtering target 3 by a beam 9. The input end of the X-ray fluorescence probe 10 is being directed towards the selected part 19 of the sputtering target 3. The X-ray fluorescence signal is being collected from the part 19 of the sputtering target 3 by the probe's 10 input end facing the sputtering target 3 and directed the collected X-ray fluorescence signals towards the X-ray energy sensitive detector 11. The detector 11 transmits the detected signals to the means 21 for processing and interpreting the signals received. After processing and interpreting the signals received, the respective signal is transmitted to the means 22, which provides a respective command to the means 20 and 20' for supplying of an inert and reactive gas into the vacuum chamber 1. The command to the means 20 and 20' can be increasing the oxygen input rate in response to increase of quantity of radiation being emitted from the sputtered metal target; and decreasing the oxygen input rate in response to decrease of quantity of radiation being emitted from the sputtered metal target.

According to the preferred embodiment, before providing a respective command to the means 20 and 20' for supplying of an inert and reactive gas into the vacuum chamber 1, the input end of the X-ray fluorescence probe 10 is being directed towards other parts of the sputtering target 3. The respective steps are repeated as many times, as necessary to measure the quantity of X-ray fluorescence being emitted from the whole surface of the sputtering target 3, or at least its substantial part. Then the measuring result are processed and the respective command is given to the means 20 and 20', thus ensuring controlling a reactive sputtering deposition of a selected material.

The invention allows to improve the quality of the coating obtained as a result of reactive sputtering deposition, as well as to considerably increase time-effectiveness of the reactive sputtering process.

### Examples of implementation of the Invention

Control of reactive sputtering process of transparent conducting oxide (TCO) thin films. Example of apparatus and method are present which use X-ray fluorescence techniques to determine the poisoning (oxidation) state of a target surface during a reactive sputtering process of TCO. The XRF apparatus includes an X-ray source (Cu or Mo targets) and an X-ray energy sensitive detector (silicon drift detector). The X-ray source produces primary X-ray photons formed into an X-ray beam, and the X-ray beam is directed to the target surface of the vacuum reactive sputtering chamber. The X-ray detector is positioned to receive X-ray fluorescence photons emitted by the target surface. Different target surface points including erosion zone can be selected. A fraction of the X-ray photons emitted by the target surface is inverse proportional to the poisoning (oxidation) of the target surface. The poisoning (oxidation) of the target surface is determined from the decrease of the intensity of X-ray photons emitted by the target surface and received by the X-ray detector within a predetermined exposure time. The X-ray energy sensitive detector produces an output signals corresponding to the energy levels of the target element atoms. The signals are proportional to the intensities received by the X-ray detector.

A first example of ZnO:Al (AZO) thin films production by reactive sputtering process of Zn:Al metal target in an oxygen and argon gas mixture were obtained. A second example of Indium-Tin oxide (ITO) TCO thin films production by reactive sputtering process of In:Sn metal target in an oxygen and argon gas mixture were obtained. A XRF device was made to contain an x-ray source and a XRF energy sensitive silicon drift detector. Vacuum conditions were created at the front end of the XRF device. The XRF device was then used to analyze the first and second examples while under the vacuum. The XRF spectrum produced by the invention when a sputtered target (Zn:Al) contains XRF lines of Zn K-alfa (8616 eV) and Al K-alfa (1486 eV). The XRF spectrum produced by the invention when a sputtered target (Zn:Al) contains XRF lines of In K-alfa (24002 eV) and Sn K-alfa (25044 eV).

## Claims

1. A device for controlling a reactive sputtering deposition of a selected material, comprising:
a vacuum chamber (1); a means (20, 20') for supplying of an inert and reactive gas into the vacuum chamber (1); a probe unit (10) adapted to be placed inside of the vacuum chamber (1) and adapted to collect radiation signals and direct them to a signal detecting unit; a source (2) adapted for generating plasma and/or creating a flux of sputtered particles of material; a means (5) adapted for holding or placing on it a substrate (5') to be subjected to sputtering of a selected material; an X-ray source (8) adapted to expose a sputtering target (3) by an X-ray beam (9), **characterized in that** the device further comprises:
- a means (21) for processing the detected signals and interpreting the signals received connected with a means (22) adapted for providing a command to the means (20, 20') for supplying of an inert and/or reactive gas into the vacuum chamber (1);
- an X-ray fluorescence polycapillary confocal probe (10) comprising an X-ray optic (15); where the probe (10) is adapted to collect the X-ray fluorescence signal from a selected part (19) of the sputtering target (3); wherein the X-ray fluorescence probe (10) is provided with an y- and/or z- axis manipulator (12) allowing to direct the input end of the X-ray fluorescence probe (10) in y- and/or z- axis direction;
- an X-ray energy sensitive detector (11) being optically connected with the probe (10) such as to enable the X-ray optic (15) to direct X-ray fluorescence beam towards the detector (11) from the optic's (10) input end facing the surface of the sputtering target (3); where the X-ray energy sensitive detector (11) is being connected at least with the means (21) for processing the detected signals or interpreting the signals received on the state of oxidation of the target.

2. A method for controlling a reactive sputtering deposition of a selected material, comprising the steps of sputtering the selected material from a sputtering target (3) toward a substrate (5') at a predetermined electrical power; monitoring the quantity of radiation being emitted from the studied area; adjusting the relative pressure of the inert and/or reactive gas so that the quantity of the radiation being emitted from the studied area becomes predetermined one, **characterized in that** the studied area is a part (19) of the surface of the sputtering target (3) and the quantity of radiation being monitored is the quantity of X-ray fluorescence being emitted from the sputtering target (3), wherein the step of monitoring the quantity of X-ray fluorescence being emitted from the sputtering target (3) comprises:
(i) exposing to radiation of the sputtering target (3) by a beam (9) from an X-ray source (8),
(ii) directing an input end of an X-ray fluorescence probe (10) towards the sputtering target (3) to enable collection the X-ray fluorescence signal from a selected part (19) of the sputtering target (3);
(iii) collecting the X-ray fluorescence signals by the probe's (10) input end facing the sputtering target (3) and directing the collected X-ray fluorescence signals towards an X-ray energy sensitive detector (11);
(iv) directing an input end of the X-ray fluorescence probe (10) to another part of the sputtering target (3), wherein the input end of the X-ray fluorescence probe (10) is being moved in y- and/or z- axis direction;
(v) collecting the X-ray fluorescence signals by the probe's (10) input end facing the sputtering target (3) and directing the collected X-ray fluorescence signals towards an X-ray energy sensitive detector (11);
wherein the steps (iv) and (v) are repeated as many times, as necessary to measure the quantity of X-ray fluorescence being emitted from the whole surface of the sputtering target (3), or at least its substantial part.

## Patentansprüche

1. Vorrichtung zum Steuern einer reaktiven Sputterabscheidung eines ausgewählten Materials, umfassend:
eine Vakuumkammer (1); ein Mittel (20, 20') zum Zuführen eines inerten und reaktiven Gases in eine Vakuumkammer (1); eine Sonde (10), die angepasst ist, um sie in den Innenraum der Vakuumkammer (1) einsetzen zu können und Strahlungssignale zu erfassen und diese an ein Signalerkennungsgerät zu senden, eine Quelle (2), die adaptiert wurde, um Plasma oder einen Fluss von gesputterten Materialpartikeln zu erzeugen; ein Mittel (5), das zum Halten oder Platzieren eines Substrats (5') adaptiert wurde und dem Sputtern mit demausgewählten Material ausgesetzt wird; eine Röntgenstrahlenquelle (8), die so gestaltet ist, dass ein Sputterziel (3) von einem Röntgenstrahl (9) belichtet wird, ist **dadurch gekennzeichnet, dass** die Vorrichtung ferner umfasst:
- eine Einrichtung (21) zum Verarbeiten der erfassten Signale und zum Interpretieren der empfangenen Signale, die mit einer Einrichtung (22) verbunden ist, welche der Einrichtung (20, 20') einen Befehl zum Zuführen eines inerten und/oder reaktiven Gases in die Vakuumkammer (1) erteilt;
- eine konfokale Röntgenfluoreszenz-Polykapillarsonde (10) mit einer Röntgenoptik (15); wobei die Sonde (10) geeignet ist, das Röntgenfluoreszenzsignal von einem ausgewählten Teil (19) des Sputtertargets (3) zu erfassen; wobei die Röntgenfluoreszenzsonde (10) mit einem Y- und/oder U-Achsen-Manipulator (12) versehen ist, der es ermöglicht, das Eingangsende der Röntgenfluoreszenzsonde (10) in die Y- und/oder Z-Achsrichtung zu lenken;
- ein röntgenenergieempfindlicher Detektor (11), der optisch mit der Sonde (10) verbunden ist, um der Röntgenoptik (15) zu ermöglichen, den Röntgenfluoreszenzstrahl vom Eingangsende der Optik (10, das der Fläche des Sputterziels (3) zugewandt ist, auf den Detektor (11) zu richten; wobei der röntgenenergetische Detektor (11) zumindest mit der Einrichtung (21) verbunden ist, um die erfassten Signale zu verarbeiten oder die Signale, die über den Oxidationszustand des Ziels Auskunft geben, zu interpretieren.

2. Verfahren zum Steuern einer reaktiven Sputterabscheidung eines ausgewählten Materials, umfassend die Schritte des Sputterns des ausgewählten Materials von einem Sputterziel (3) auf ein Substrat (5 ') mit einer vorbestimmten elektrischen Leistung; Überwachen der Strahlungsmenge, die aus dem untersuchten Gebiet ausgesendet wird; Einstellen des relativen Drucks des inerten und/oder reaktiven Gases, so dass die Menge der aus dem untersuchten Bereich emittierten Strahlung vorbestimmt wird, **dadurch gekennzeichnet, dass** die untersuchte Fläche ein Teil (19) der Oberfläche des Sputterziels (3) ist und die überwachte Strahlungsmenge die Menge an Röntgenfluoreszenz ist, die vom Sputterziel (3) emittiert wird, wobei der Schritt des Überwachens der Röntgenfluoreszenzmenge, die vom Sputterziel (3) emittiert wird, umfasst:
(i) Bestrahlung des Sputterziels (3) mit einem Strahl (9) einer Röntgenquelle (8),
(ii) Ausrichten eines Eingangsendes einer Röntgenfluoreszenzsonde (10) auf das Sputterziel (3), um das Erfassen des Röntgenfluoreszenzsignals von einem ausgewählten Teil (19) des Sputterziels (3) zu ermöglichen;
(iii) Erfassen der Röntgenfluoreszenzsignale durch das Eingangsende der Sonde (10), das dem Sputterziel (3) zugewandt ist, und Ausrichten der erfassten Röntgenfluoreszenzsignale auf einen röntgenenergieempfindlichen Detektor (11);
(iv) Ausrichten eines Eingangsendes der Röntgenfluoreszenzsonde (10) auf einen anderen Teil des Sputterziels (3), wobei das Eingangsende der Röntgenfluoreszenzsonde (10) in Y- und/oder Z-Achsenrichtung bewegt wird.
(v) Erfassen der Röntgenfluoreszenzsignale durch das Eingangsende der Sonde (10), das dem Sputterziel (3) zugewandt ist, und Ausrichten der erfassten Röntgenfluoreszenzsignale auf einen röntgenenergieempfindlichen Detektor (11);
wobei die Schritte (iv) und (v) so oft wie notwendig wiederholt werden, um die Menge an Röntgenfluoreszenz, die von der gesamten Oberfläche des Sputterziels (3) oder zumindest von seinem wesentlichen Teil emittiert wird, zu messen.

## Revendications

1. Dispositif permettant de commander un dépôt par pulvérisation réactive d'un matériau sélectionné, comprenant :
une chambre à vide (1) ; un moyen (20, 20') d'alimentation d'un gaz inerte et réactif dans la chambre à vide (1) ; une unité de sonde (10) conçue pour être placée à l'intérieur de la chambre à vide (1) et conçue pour collecter des signaux de rayonnement et les diriger vers une unité de détection de signal ; une source (2) conçue pour générer un plasma et/ou créer un flux de particules de matériau pulvérisées ; un moyen (5) conçu pour maintenir ou placer sur celui-ci un substrat (5') devant être soumis à une pulvérisation d'un matériau sélectionné ; une source de rayons X (8) conçue pour exposer une cible de pulvérisation (3) par un faisceau de rayons X (9), **caractérisé en ce que** le dispositif comprend en outre :
- un moyen (21) de traitement des signaux détectés et d'interprétation des signaux reçus connecté à un moyen (22) conçu pour fournir une commande au moyen (20, 20') d'alimentation d'un gaz inerte et/ou réactif dans la chambre à vide (1) ;
- une sonde confocale polycapillaire de fluorescence X (10) comprenant un élément optique à rayons X (15) ; où la sonde (10) est conçue pour collecter le signal de fluorescence X provenant d'une partie sélectionnée (19) de la cible de pulvérisation (3) ; dans lequel la sonde de fluorescence X (10) comporte un manipulateur d'axes y et/ou z (12) permettant de diriger l'extrémité d'entrée de la sonde de fluorescence X (10) dans la direction des axes y et/ou z ;
- un détecteur (11) sensible à l'énergie de rayons X étant relié optiquement à la sonde (10) de façon à permettre à l'élément optique à rayons X (15) de diriger un faisceau de fluorescence X vers le détecteur (11) à partir de l'extrémité d'entrée de l'élément optique (10) faisant face à la surface de la cible de pulvérisation (3) ; où le détecteur (11) sensible à l'énergie de rayons X est connecté au moins au moyen (21) de traitement des signaux détectés ou d'interprétation des signaux reçus sur l'état d'oxydation de la cible.

2. Procédé de commande d'un dépôt par pulvérisation réactive d'un matériau sélectionné, comprenant les étapes consistant à pulvériser le matériau sélectionné à partir d'une cible de pulvérisation (3) vers un substrat (5') à une puissance électrique prédéterminée ; surveiller la quantité de rayonnement émis provenant de la zone étudiée ; ajuster la pression relative du gaz inerte et/ou réactif de sorte que la quantité du rayonnement étant émis à partir de la zone étudiée devient la quantité prédéterminée, **caractérisé en ce que** la zone étudiée est une partie (19) de la surface de la cible de pulvérisation (3) et la quantité de rayonnement étant surveillée est la quantité de fluorescence X étant émise à partir de la cible de pulvérisation (3), dans lequel l'étape de surveillance de la quantité de fluorescence X étant émise à partir de la cible de pulvérisation (3) comprend :
(i) l'exposition à un rayonnement de la cible de pulvérisation (3) par un faisceau (9) provenant d'une source de rayons X (8),
(ii) l'orientation d'une extrémité d'entrée d'une sonde de fluorescence X (10) en direction de la cible de pulvérisation (3) pour permettre la collecte du signal de fluorescence X provenant d'une partie sélectionnée (19) de la cible de pulvérisation (3) ;
(iii) la collecte des signaux de fluorescence X par l'extrémité d'entrée de la sonde (10) faisant face à la cible de pulvérisation (3) et l'orientation des signaux de fluorescence X collectés vers un détecteur (11) sensible à l'énergie de rayons X ;
(iv) l'orientation d'une extrémité d'entrée de la sonde de fluorescence X (10) vers une autre partie de la cible de pulvérisation (3), dans lequel l'extrémité d'entrée de la sonde de fluorescence X (10) est déplacée dans la direction des axes y et/ou z ;
(v) la collecte des signaux de fluorescence X par l'extrémité d'entrée de la sonde (10) faisant face à la cible de pulvérisation (3) et l'orientation des signaux de fluorescence X collectés vers un détecteur (11) sensible à l'énergie de rayons X ;
dans lequel les étapes (iv) et (v) sont répétées autant de fois que nécessaire pour mesurer la quantité de fluorescence X étant émise à partir de la surface entière de la cible de pulvérisation (3), ou au moins une partie importante.
